(19) Europäisches Patentamt
European Patent Office
Office européen des brevets

(11) **EP 4 137 889 A1**

(12) **EUROPEAN PATENT APPLICATION**

(43) Date of publication:
**22.02.2023 Bulletin 2023/08**

(21) Application number: **21192381.8**

(22) Date of filing: **20.08.2021**

(51) International Patent Classification (IPC):
**G03F 7/20** (2006.01)

(52) Cooperative Patent Classification (CPC):
**G03F 7/70616**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **NIENHUYS, Han-Kwang**
**5500 AH Veldhoven (NL)**
• **HELFENSTEIN, Patrick Philipp**
**5500 AH Veldhoven (NL)**
• **ROOBOL, Sander Bas**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY MEASUREMENT METHOD AND APPARATUS**

(57) Disclosed is a method of measuring a target on a substrate using a metrology tool comprising an illumination source operable to emit an illumination beam for illuminating the target and a metrology sensor for collecting the scattered radiation having been scattered by the target. The method comprises calculating a target angle based on cell dimensions of a unit cell of said target in a first direction and a second direction orthogonal to said first direction; and order numbers of a selected pair of complementary diffraction orders in said first direction and second direction. At least one pair of measurement acquisitions is performed at a first target orientation and a second target orientation with respect to the illumination beam, wherein said target angle for at least one of said at least one pair of measurement acquisitions is an oblique angle.

Fig. 11

**Description**

<u>FIELD</u>

The present invention relates to methods and apparatus for use in measuring parameters of a structure fabricated in or on a substrate. Specific arrangements may relate to, but need not be limited to, measurement of overlay or side wall angle.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation, or called a drive radiation (e.g., infrared IR radiation) to excite a generating medium, thereby generating an emitted radiation, optionally a high harmonic generation comprising high frequency radiation.

In specific known arrangements, overlay metrology can be performed by illuminating, using electromagnetic radiation, an overlay target or other structure and measuring radiation diffracted or reflected from the overlay target. The target may comprise two gratings on top of each other. Asymmetry in the diffracted radiation is defined as the difference between an intensity of the negative and corresponding positive diffraction orders, for example the difference between the -1st and +1st diffraction orders. This asymmetry is dependent on the lateral shift (the overlay shift) between the top and bottom grating of the overlay target. The asymmetry of an overlay grating thus allows evaluation of overlay.

As used herein, the term "intensity" encompasses incident power (in watts) of radiation, which may be SXR radiation, per unit area. In exemplary arrangements disclosed, the area may be detector or sensor area. The term "signal" encompasses an electrical charge collected by a detector (or sensor) pixel during an exposure. The signal may be expressed in coulombs or in analog-digital units (ADU). The signal is proportional to irradiance and exposure time (the proportionality constant is wavelength dependent). The term "reflectance" encompasses the ratio of diffracted spectral flux to spectral flux incident upon a target. The reflectance may depend on the target properties, target orientation, the wavelength, and/or the diffraction order number. The reflectance of a target may vary (drift) over time. Reflectance may be measured as an average over an exposure time.

Such evaluation typically requires calibration of the relation between asymmetry and overlay (in other words, the extraction of the sensitivity of overlay to asymmetry). This can be done using measurements on multiple overlay targets with known overlay shifts (overlay biases). One exemplary calibration method uses measurements on two overlay targets with different overlay shift to extract overlay (and the sensitivity).

In the absence of system (or tool) asymmetries (e.g. sensor asymmetries) a single measurement of the diffracted radiation from a target suffices for overlay extraction. System asymmetry (e.g. a different gain of the detector for the -1st order compared to the 1st order) adds non-overlay asymmetry to the asymmetry determined based on the diffracted radiation. To remove this tool-induced asymmetry a second measurement on the same target is done after the target has been rotated in-plane by 180 degrees. The first measurement is referred to as the nominal target orientation measurement, the second one as the rotated target orientation measurement. The rotated measurement results in diffracted radiation from the target that is also rotated. However, a tool-induced asymmetry will not be rotated. Thus, the combination of nominal and rotated measurement allows distinction of overlay asymmetry from system asymmetry.

This approach is effective for 1D periodic targets. However, when measuring 2D periodic targets, e.g., to measure overlay in both substrate plane directions on a single target, this approach does not work.

As such, an improved method for correcting for system or tool asymmetry when measuring 2D-periodic targets is desirable.

SUMMARY

In a first aspect of the invention there is provided a method of measuring a target on a substrate using a metrology tool comprising an illumination source operable to emit an illumination beam for illuminating the target and a metrology sensor for collecting the scattered radiation having been scattered by the target, the surface of said substrate defining a substrate plane extending over a first tool direction and a second tool direction orthogonal to said first tool direction, where the first tool direction, second tool direction and a third tool direction orthogonal said first tool direction and second tool direction together defines a tool coordinate system, the method comprising: performing at least one pair of measurement acquisitions, said at least one pair of measurement acquisitions comprising a first measurement acquisition of the target at a first target orientation with respect to the illumination beam; and a second measurement acquisition of the target at a second target orientation with respect to the illumination beam, wherein said first target orientation is defined by a target angle between a target coordinate system and said tool coordinate system around an axis perpendicular to the substrate plane, wherein said target angle for at least one of said at least one pair of measurement acquisitions is an oblique angle; and determining a measurement acquisition from the first measurement acquisition and second measurement acquisition, optionally the measurement acquisition is a corrected measurement acquisition being corrected for asymmetry contributions due to the illumination beam and/or metrology sensor.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts diffraction patterns for (a) a prior art mirror symmetry tool asymmetry correction method and (b) a point symmetry tool asymmetry correction method;
- Figure 9 is a flow diagram depicting steps of a method according to a first embodiment;
- Figure 10 is a flow diagram depicting steps of a method according to a second embodiment;
- Figure 11 depicts diffraction patterns for the method described by the flow diagram of Figure 10;
- Figure 12 is a plot of spectral power against wavenumber illustrating a typical HHG output spectrum;
- Figure 13 is a plot of spectral power against $q_z$ values illustrating a mapping of a discrete-wavelength spectrum to $q_z$ values for three azimuthal angles; and
- Figure 14 illustrates example captured diffraction patterns for each of target orientations chosen to perform a full tool-asymmetry correction according to an embodiment.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

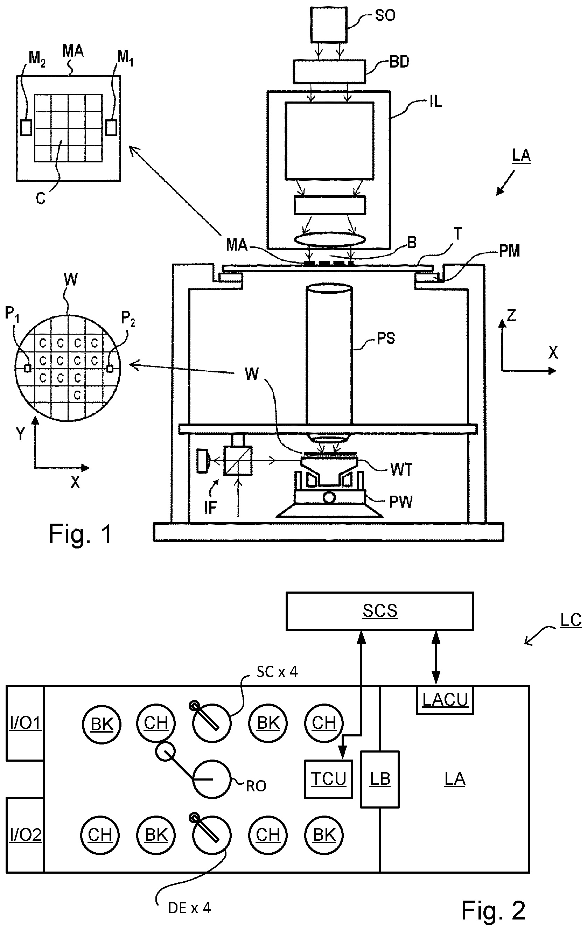

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a metrology sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

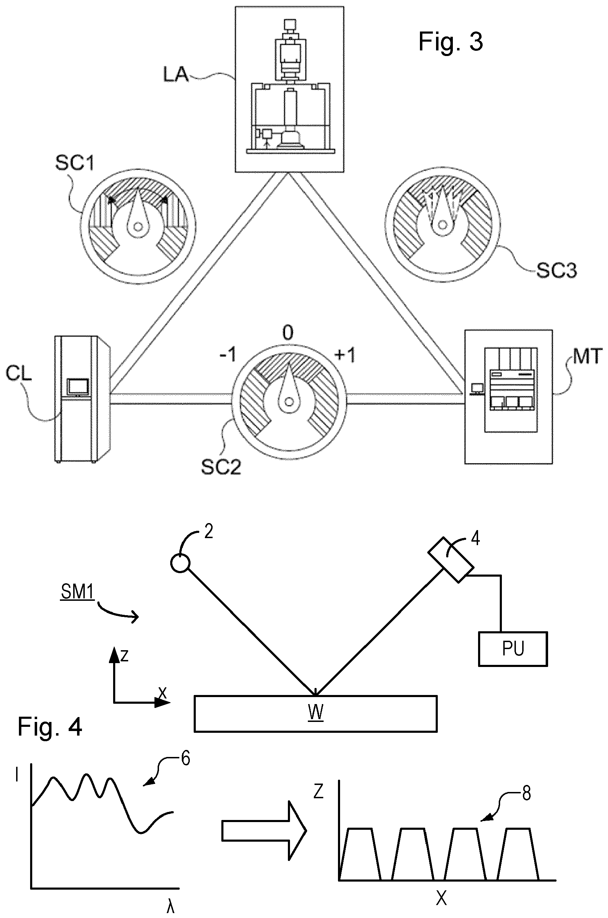

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

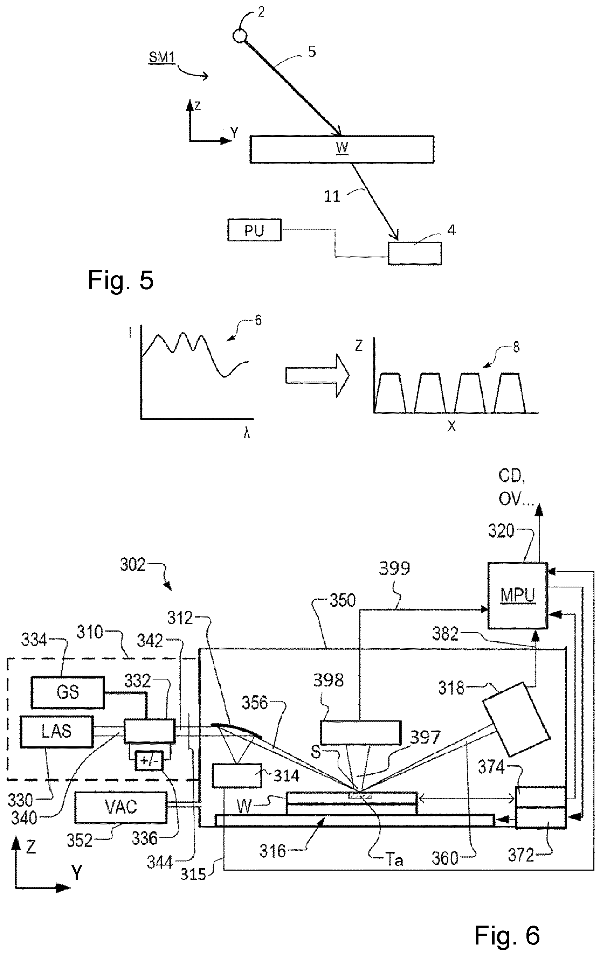

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1 nm, optionally < 0.1 nm, optionally < 0.01 nm.

As an alternative to optical metrology methods, it has also been considered to use hard X-ray, soft X-rays or EUV radiation, for example radiation with at least one of the wavelength ranges: < 0.01 nm, < 0.1 nm, <1 nm, between 0.01 nm and 100 nm, between 0.01 nm and 50 nm, between 1nm and 50 nm, between 1 nm and 20 nm, between 5 nm and 20 nm, and between 10 nm and 20 nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398, and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source or free electron laser (FEL) source.

For the example of HHG source, as shown in Figure 6, main components of the radiation source are a pump/drive radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be for example in the region of 1 $\mu$m (1 micron). Optionally, the laser pulses are delivered as a first pump radiation 340 to the gas delivery system 332, where in the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example a noble gas such as Neon (Ne), Helium (He) or Argon (Ar). Nitrogen ($N_2$), oxygen ($O_2$),

Argon (Ar), Krypton (Kr), Xenon (Xe) gases may all be considered. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-21 nm or optionally in the range 1-10 nm or optionally in the range 9-21 nm may be chosen.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target T has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target T are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or inverse Compton scattering (ICS) to obtain radiation at the desired wavelength(s).

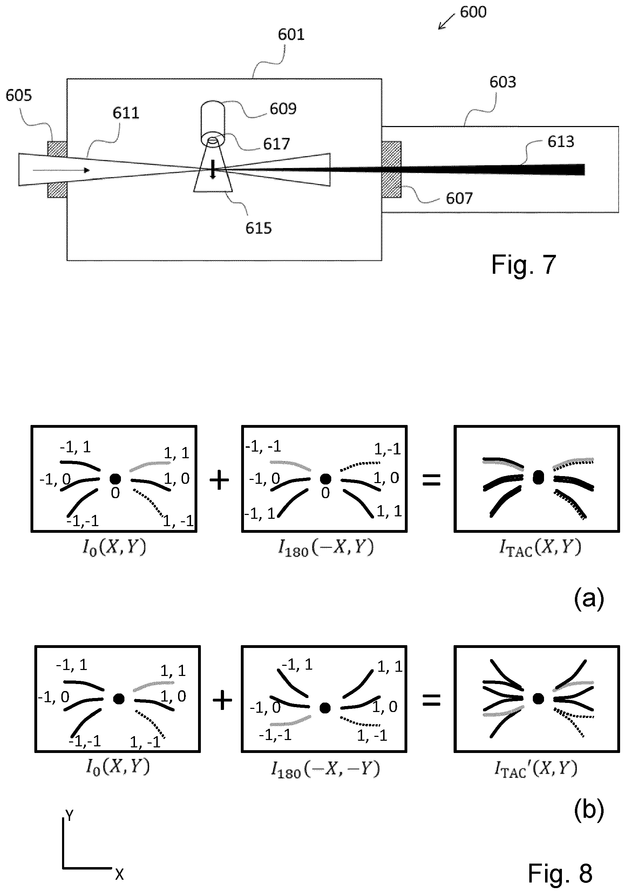

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (e.g., a noble gas, optionally Helium, Argon, Xenon, or Neon, nitrogen, oxygen or carbon dioxide) in which the gas pressure is above a certain value. The gas flow 615 may be a steady flow. Other media, such as metallic plasmas (e.g. Aluminum plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. In almost all the prior arts, the gas nozzle has a cut tube geometry shape which is a uniform cylinder interior geometry shape, and the shape of the opening in the exit plane is round. An elongated opening has also been used as described in the patent application CN101515105B.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive and negative complementary diffraction orders (e.g., +1st and -1st diffraction orders), where +/- diffraction orders of the same order number are complementary diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

The concepts disclosed herein will be described largely in the context of SXR metrology, due to an issue of SXR metrology tools such as illustrated in Figure 6 being fundamentally asymmetric in reflection in the YZ plane (e.g., asymmetry upon reversing the X axis). However, the concepts herein are also applicable to metrology tools which use other radiations (e.g., electron beam), wavelengths (e.g., visible, hard X-ray, and/or IR wavelengths) and/or a normal incidence for the measurement beam. In this description, coordinates XYZ are defined as the tool coordinates, with the target in the XY plane and illumination in the YZ plane (as illustrated in Figure 6). The target coordinate system is xyz, with the x- and y-axes aligned with the sides of a (assumed) rectangular unit cell, which may be the edges of the target pads or direction of the target periodicity, and the z-axis perpendicular to the target plane, which may be the substrate plane. The target rotation angle is defined as the z-rotation angle between the xyz and XYZ coordinate systems. For example, target orientation 0 deg means that xy = XY, and target orientation 90 deg means xy = +Y-X. Pupil coordinates can be in terms of xy or in terms of XY.

The metrology tool may comprise a pupil based detector (i.e., a detector or camera at a pupil plane or Fourier plane of the metrology tool). This enables selection of certain diffraction orders as will be described below. However, the concepts described herein are also applicable to image based detectors (detection at an image plane of the metrology tool). For such tools, a configurable (e.g., programmable) mask at a pupil plane of the tool may be provided to enable selection of the required orders; however the fundamental methods will remain the same. It is therefore to be understood that the embodiments below are purely exemplary and no limitation to a wavelength range or region, detection location/method and/or incidence angle is intended nor should it be inferred.

In SXR metrology, a target may be illuminated with a broadband SXR beam (e.g., having a wavelength range 10 nm - 20 nm), with the diffracted/scattered light captured on an image sensor. The target has a periodic pattern, which may comprise, for example, a 1D-periodic pattern (e.g., parallel lines) or 2D-periodic pattern (e.g., rectangular unit cell). A target comprises a 2D-periodic pattern is a two-dimensional target. The two-dimensional periodicities are in two orthogonal directions on the substrate plane, optionally the periodicities in two directions are bigger than or comparable to half of the illumination wavelength so that the periodicities in two directions can be distinguished by the illumination.

The diffraction pattern is processed and may be translated into a parameter of interest such as, for example, overlay, focus, CD, 3D Edge Placement Error (EPE), and profile parameter e.g., side wall angle (SWA).

The intensity profile in the diffraction pattern is not only affected by the properties of the target, but also by properties of the measurement tool. In particular, an issue referred to herein as "tool asymmetry" can have an undesirable impact on a measurement. Tool asymmetry may describe tool properties which result in a difference between the diffraction pattern in the +X direction compared to the diffraction pattern in the -X direction. Tool asymmetry can be caused, for example, by the polarization of the illumination beam (the beam used to measure the target) not being pure s-polarization or p-polarization or by a beam profile that is not mirror symmetric with respect to the Y-axis.

One known way to address this issue, applicable for example when using an SXR metrology tool such as illustrated in Figure 6, is to perform two measurements on each single target: a first acquisition with the target in a first target or nominal target orientation, and a second acquisition with the target in a second target or rotated target orientation, the rotation being 180 degrees along its normal with respect to the nominal configuration. This results in a first diffraction intensity pattern $I_0(X, Y)$ and second diffraction intensity pattern $I_{180}(X, Y)$, where $X, Y$ are sensor (tool) coordinates. A tool-asymmetry-corrected (TAC) image $I_{TAC}(X, Y)$ may then be constructed as:

$$I_{TAC}(X,Y) = I_0(X,Y) + I_{180}(-X,Y). \quad (\text{eq. }1)$$

This requires that X = 0 is properly defined, which is generally possible.

The asymmetry quantity $A(X)$ may then be defined as:

$$A(X) = \int \left[ I_{\text{TAC}}(X) - I_{\text{TAC}}(-X) \right] dY, \quad (\text{eq. } 2)$$

which comprises only asymmetry contributions from the target, and therefore no asymmetry contributions from the tool. The quantity $I_{\text{TAC}}$ is not always calculated explicitly as an intermediate step, but the end result is mathematically the same.

This approach, where a target is measured at rotation angles 0 deg and 180 deg, works for determination of overlay (or other parameter) in a single direction (i.e., equations eq. 1 and eq. 2 can be used in a determination of overlay in x) based on measurement of a 1D-periodic target. However, this approach breaks down when measuring 2D-periodic targets. While the non-perfect reflection symmetry along the sensor Y-axis is due to minor tool imperfections, the tool is fundamentally asymmetric on reflection with respect to the sensor X-axis.

For a 2D-periodic target comprising a unit cell that has reflection symmetry with respect to the (target) y-axis, Equation eq. 1 could be used. However, if the target unit cell does not have reflection symmetry, for example due to non-zero overlay in both x and y, or because the target is not symmetric by design, then this will not work. For example, for a target with a square unit cell, the scenario where overlay in x is equal to overlay in y would lead to an additional imbalance mostly between the (1,1) and (-1, -1) diffraction orders, and no imbalance between the (1, -1) and (-1,1) orders. The symmetrizing operation of Equation eq. 1 does not address the tool asymmetry in Y.

Figure 8(a) illustrates this issue with respect to the present method embodied by Equation eq. 1. A first diffraction image $I_0(X, Y)$ is obtained at the first orientation, comprising the zeroth order 0, and 6 diffraction orders (-1, 1), (-1, 0), (-1, -1), (1, 1), (1, 0), (1, -1) (other higher orders may also be captured by the tool but are not shown here). A second diffraction image $I_{180}(-X, Y)$ comprises a representation of the diffraction image captured at the second orientation (nominal +180 degrees), and transformed according (-X, Y). Also shown is the combined image or tool asymmetry corrected image $I_{\text{TAC}}(X, Y)$ (a slight offset in Y between the two diffraction patterns has been added for clarity). The diffraction orders represented by solid black lines are those corresponding to a target that has reflection symmetry in the xz and yz planes and a hypothetical ideal, symmetric tool. The diffraction orders represented by solid gray lines indicate a diffraction order that is solely affected by tool asymmetry and diffraction orders represented by dotted black lines indicate a diffraction order solely affected by target asymmetry.

The dark gray orders (order (1, 1) in the first image and (-1, -1) in the second image) illustrate that the tool asymmetry is corrected in the tool asymmetry corrected image $I_{\text{TAC}}(X, Y)$; i.e., the first image $I_0(X, Y)$ and its transform $I_{180}(-X, Y)$ are symmetrical around the Y-axis with respect to the tool. The light gray shading for order (1, -1) in the two images illustrate that this correction strategy does not work for target features of a 2D mark as there is no symmetry for these orders in X or Y for the two images.

Intuitively, an alternative symmetrizing operation may be envisaged, according to:

$$I_{\text{TAC}}{}'(X,Y) = I_0(X,Y) + I_{180}(-X,-Y). \quad (\text{eq. } 3)$$

This would generate an image that has point symmetry with respect to the origin. However, it does not guarantee a result that has reflection symmetry along either X = 0 or Y = 0 in the absence of target asymmetry, so this would not work. Figure 8(b) is an equivalent figure to that of Figure 8(a) illustrating this symmetrizing operation. It can be seen that the tool has point symmetry but the target features are scrambled.

Another proposal may comprise measuring the target in steps of 90 degrees. This proposal then determines X-overlay from a combination of the 0 deg and 180 deg images using Equation eq. 1, and the Y-overlay from a combination of the 90 deg and 270 deg images using a trivial variant of Equation eq. 1. This would require biased targets. A major disadvantage with this proposal is that it is fundamentally impossible to separate overlay from other target asymmetries such as sidewall asymmetry. Additionally, it would not work for unit cells which lack reflection symmetry by design.

To address the issues raised above, it is proposed that TAC data of complementary diffraction- order pairs ($m_x$, $m_y$), ($-m_x$, $-m_y$), such as (1, 2) versus (-1, -2), are obtained by rotating the target such that one such pair generates a diffraction pattern that has reflection symmetry with respect to the sensor Y-axis.

Specifically, for a target with unit cell dimensions $L_x \times L_y$, a diffraction order pair ($m_x$, $m_y$), ($-m_x$, $-m_y$) will be symmetric on the image sensor if the target is rotated by a target angle or angle $\alpha$:

$$\alpha = \text{atan2}(m_y L_x, \ m_x L_y) \quad (\text{eq. } 4)$$

where ($m_x$, $m_y$) represents a diffraction order; the numbering of the diffractions orders may be fixed relative to the target (x, y axes).

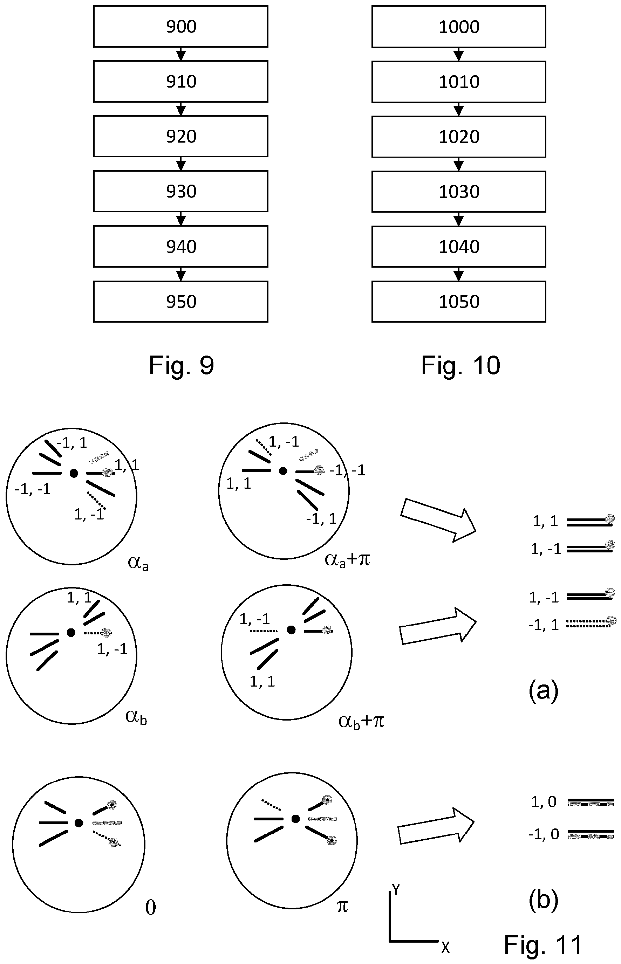

Figure 9 is a flowchart describing a method according to such an embodiment. At step 900, ($m_x$, $m_y$) order pairs are chosen with $m_x \geq 0$ ; for example the order pairs may comprise (0,1), (1, 0), (1, 1), (1, -1) and their complementary orders. At step 910, based on the unit-cell dimensions $L_x$, $L_y$, angles $\alpha$ are evaluated according to Equation eq. 4. For example, if $L_y/L_x$ = 2, the angles will be [90, 0, 26.56, -26.56] degrees, respectively. As such, some of the angles are oblique angles (i.e., an angle other than 0, 90, 180 or 270 degrees, the target rotation angle defined as the z-rotation angle between the xyz and XYZ coordinate systems of the target and sensor respectively). Step 920 comprises obtaining two diffraction patterns (e.g., first and second measurement acquisitions) for each target angle $\alpha$ value: a first at $\alpha$ degrees $I_\alpha(X, Y)$ and a second at $\alpha$ + 180 degrees $I_{\alpha+180\ deg}(X, Y)$. Step 930 comprises symmetrizing to find $I_{TAC,\alpha}(X, Y)$; i.e., as $I_{TAC,\alpha}(X, Y) = I_\alpha(X, Y) + I_{\alpha+180\ deg}(-X, Y)$. Step 940 comprises, for each $\alpha$, identifying the corresponding order pair in the diffraction pattern; for example for $\alpha$ = 26.56 degrees, this step may comprise identifying the orders (1,1) and (-1, -1). Finally, at step 950, pixel values are mapped to a spectrum as a function of wavelength or other suitable wavelength-related quantity (e.g., wavenumber, distance from the zeroth order in pupil coordinates, inverse pupil space or $q_z$ value, etc.), and feed into further processing.

Mapping to pupil coordinates may comprise a mapping from a signal represented as a detector image $I(X, Y)$ to the same signal represented in pupil space, $\hat{I}(\kappa)$. The parameter $\kappa$ represents the ($\kappa_x$, $\kappa_y$) vector in pupil space, i.e., the x and y components of the direction unit vector ($\kappa_x$, $\kappa_y$, $\kappa_z$) of a ray, with the target in the xy plane. The representation in pupil space may be continuous, rather than in terms of discrete pixels; this can be achieved using a suitable interpolation method.

Many of the embodiments disclosed herein comprise mapping a diffraction efficiency $R_{m\lambda}(m, \lambda)$ (or related quantity such as intensity) as function of order number m and wavelength $\lambda$ to inverse pupil space or reciprocal space as $R_{mq}(m, q_z)$, where $q_z$ has the dimension of inverse length.

Mapping to an inverse pupil space may comprise an application of the following sequence of transformations to measured signals to transform the raw data to inverse pupil space:

- Transform the detector images to pupil space, i.e., a signal $Y_\kappa(\kappa_x, \kappa_y)$. This requires knowing the locations of the detector pixels in 3D space.
- Transform pupil space to inverse coordinates $q_x$, $q_y$, $q_z$, to obtain inverse coordinate measurement data. This will be described in more detail below.
- Apply a Fourier transform to the signal in inverse space.

In 3D reciprocal space (with the target being in the xy plane and periodic along x with period $p_x$ and periodic in y with period $p_y$) or momentum transfer space, the momentum transfer vector may be defined as:

$$\boldsymbol{q}_{m_x,m_y} = \begin{pmatrix} (\tilde{\boldsymbol{v}}_{m_x,m_y} - \tilde{\boldsymbol{v}}_{0,0}) \cdot \boldsymbol{e}_x \\ (\tilde{\boldsymbol{v}}_{m_x,m_y} - \tilde{\boldsymbol{v}}_{0,0}) \cdot \boldsymbol{e}_y \\ (\tilde{\boldsymbol{v}}_{m_x,m_y} + \tilde{\boldsymbol{v}}_{0,0}) \cdot \boldsymbol{e}_z \end{pmatrix}. \quad (eq.\ 5)$$

where $m_x$, $m_y$ are the diffraction order numbers in x and y, respectively. This can be written more compactly as:

$$\boldsymbol{q}_{m_x,m_y} = \tilde{\boldsymbol{v}}_{m_x,m_y} - \tilde{\boldsymbol{v}}_{in} \quad (eq.\ 6)$$

where $\tilde{\boldsymbol{v}}_{in}$ is the incident wavevector, which differs from $\tilde{\boldsymbol{v}}_0$ in the sign of its z component. The z-component of $q$ is consistent with $q_z$. For diffraction from a target which is periodic in x and y, the Cartesian components of q have the properties:

$$q_x = \frac{m_x}{p_x}, \qquad q_y = \frac{m_y}{p_y}, \qquad q_z = \tilde{v}(\cos\theta_1 + \cos\theta_2). \quad (eq.\ 7)$$

Or alternatively:

$$q_z = \tilde{v}\left[\sqrt{1 - \left(\kappa_x^0 + \frac{m_x}{\tilde{v}p_x}\right)^2 - \left(\kappa_y^0 + \frac{m_y}{\tilde{v}p_y}\right)^2} + \sqrt{1 - (\kappa_x^0)^2 - (\kappa_y^0)^2}\right], \quad (\text{eq. } 8)$$

where $\left(\kappa_x^0, \kappa_y^0, \kappa_z^0\right)$ is the direction unit vector of the zero-order reflected radiation.

The measured intensity or diffraction efficiency spectrum $R_{m_x,m_y}(\tilde{v})$ can be mapped to momentum-transfer space as $\tilde{R}(\mathbf{q})$ either using any of equations 5 to 7, or, equivalently, as $\hat{R}_{m_x,m_y}(q_z)$. Part of the thusly remapped $\hat{R}_{m_x,m_y}(q_z)$ can now be Fourier-transformed as:

$$R'(X,Y,Z) = \int_{q_{z,a}}^{q_{z,b}} \sum_{m_x,m_y} \hat{R}_{m_x,m_y}(q_z) \exp\left(\frac{2\pi i m_x X}{p_x} + \frac{2\pi i m_y Y}{p_y} + 2\pi i q_z Z\right) dq_z \quad (\text{eq. } 9)$$

Note that the factors $2\pi$ in this Fourier transform can also be replaced by $-2\pi$; in this case, most other factors $2\pi$ in the equations in the remainder of this ID on will also need to be replaced by $-2\pi$, as will be obvious to the person skilled in the art.

Figure 10 illustrates an alternative embodiment to that described by the flowchart of Figure 9. Because it is very time-consuming to perform two exposures on each of four (or more) diffraction order pairs, this embodiment proposes performing two exposures for only two diffraction order pairs and interpolating the remainder. This may be particularly useful if the $L_y/L_x$ ratio is large (for example >3 or > 10). It may also be useful if the ratio is small, for example <0.33 or <0.10, in which case the $x$ and $y$ labels can be swapped.

At step 1000, $(m_x, m_y)$ order pairs are chosen with $m_x \geq 0$; for example the order pairs may comprise: (1, 0), (1,1), (1, -1), (1, 2), (1, -2), (1, 3), (1, -3). At step 1010, the angles $\alpha_a$, $\alpha_b$ for only two of these pairs are evaluated, for example the order pairs (1, 3) and (1, -3). For a unit cell aspect ratio $L_y/L_x = 5$, this would yield $\alpha_a = 30.96$ and $\alpha_b = -30.96$ deg. At step 1020, the diffraction patterns for $\alpha$ and $\alpha + 180$ deg (for each of $\alpha_a$, $\alpha_b$ i.e., four in total) are obtained. At step 1030, in each diffraction pattern, the diffraction orders are identified and the pixel values mapped or transformed to a wavelength spectrum, resulting in spectra $S(\alpha, m_x, m_y, \lambda)$ and $S'(\alpha, m_x, m_y, \lambda)$, where the latter is for the $\alpha + 180$ deg target orientation and the spectrum is measured for $\alpha = \alpha_a$ or $\alpha = \alpha_b$. The spectra S and S' can represent diffraction intensities or diffraction efficiencies. A diffraction intensity spectrum can be converted into a diffraction efficiency spectrum by dividing the values by the intensity spectrum of the illumination source, which can be estimated or obtained using detector 318. At step 1040, the spectra are estimated as a continuous function of $\alpha$ by interpolation, (e.g., linear interpolation) and evaluated with $\alpha$ values corresponding to the other selected orders, e.g. (1, 0), (1, ±1), (1, ±2). Finally at step 1050, the TAC spectra are evaluated as:

$$S_{\text{TAC},\alpha}(m_x, m_y, \lambda) = S(\alpha, m_x, m_y, \lambda) + S'(\alpha, m_x, m_y, \lambda) \quad (\text{Eq. } 10),$$

where the $\alpha$ values are taken as corresponding to the $|m_x|$, $m_y$ values.

The above procedure is based on measurements at two $\alpha$ values. It can also be generalized to three or more values.

Linear interpolation is suitable if the relation is well approximated by $S(\alpha) = A + \alpha B$. It may be that the true relation turns out to be closer to a power law, e.g. $S = A + \alpha^3 B$ or generally $S = A + f(\alpha, m_x, m_y, \lambda)B$ where f is a known function and only $A$ and $B$ are target-dependent. It is straightforward to modify step 1040 accordingly.

In an embodiment, step 1040 may be replaced by a step of transforming the spectra S and S' from wavelength $\lambda$ representation to $q_z$ representation (or momentum transfer space as has been described) to obtain spectra $R(\alpha, m_x, m_y, q_z)$ and $R'(\alpha, m_x, m_y, q_z)$. A modified step 1050 may then use the interpolation as described in step 1040 to create a function R for arbitrary $\alpha$ values and to create a TAC spectrum according to:

$$R_{\text{TAC},\alpha}(m_x, m_y, q_z) = R(\alpha, m_x, m_y, q_z) + R'(\alpha, m_x, m_y, q_z) \quad (\text{Eq. } 11).$$

Optionally these steps may be followed by a transformation back to $S_{\text{TAC},\alpha}(m_x, m_y, \lambda)$.

The rationale behind this embodiment is that $R(q_z)$ varies less with the order numbers than $S(\lambda)$, which makes interpolation more attractive.

Figure 11 illustrates steps 1030 and 1040 in terms of diffraction drawings for this embodiment. Figure 11(a) shows diffraction patterns for four orientations (using radians as angle units) $\alpha_a$, $\alpha_a + \pi$, $\alpha_b$, $\alpha_b + \pi$ in $m_x$, $m_y$, $q_z$ space (where, in this example, $\alpha_b = -\alpha_a$). It can be seen that there is point symmetry in the diffraction patterns for the tool and for the target features. Figure 11(b) shows the interpolated diffraction patterns at angles $\alpha$ and 0 (where $\alpha$ is the magnitude of $\alpha_a$). Once again, light gray illustrates target asymmetry and dark gray indicates tool asymmetry.

Once again the gray coloring (gray dot and the gray line) describe diffraction orders affected by tool-related asymmetries and may be interpreted as pixels on the detector that have different responses. The black dotted lines represent diffraction orders affected by target asymmetries. The gray dotted line in Figure 11(a) (top two illustrations) indicates that there is a tool-related asymmetry at this region, but there is no diffracted light for that target rotation. In Figure 11(b), the interpolation causes the tool-asymmetry contribution to be mixed with the non-asymmetric contributions; represented here by the dashed gray/black line and the open gray circles.

As mentioned above, the intensity profile in the diffraction pattern is affected by the properties of the target as well as by the properties of the measurement tool. So far, it has not been explicitly described how pixels from the measured diffraction patterns may be mapped to the corresponding orders. If all properties of both target and measurement tool are known, this mapping can be calculated directly. In most situations however, only the pitches are known while there is little information about the stack composition and unit cell. Also, fluctuations of the source spectrum and misalignment of sample stage and detector may be considered. It is therefore proposed to add the following preprocessing steps (e.g., to step 1030 of the method described above) to obtain a better mapping of pixels to orders:

- Binarize image based on user-defined or automatically obtained (e.g. by Otsu's method) threshold.
- Segment image to obtain per-order masks (e.g., signal regions) that can be applied to the original image to obtain a more accurate pixel-to-order mapping. Image segments are found by contour search such as described in, e. g., Satoshi Suzuki et al. "Topological structural analysis of digitized binary images by border following." Computer Vision, Graphics, and Image Processing, 30(1):32-46, 1985; which is hereby incorporated herein by reference.
- Optimize obtained contours by applying morphological close and open transformations sequentially. The former removes small contours and the latter fills holes in the remaining contours.

These steps can be controlled by a small number of hyperparameters, which are easily adaptable to different experimental conditions. The obtained masks can then be applied to the original image to extract the specified diffraction orders necessary for step 1040. If required, sample and detector misalignment can be corrected by comparing the obtained masks to the calculated positions, and shifting or rotating the image accordingly. If using a simple cross-correlation approach, the corrections are limited to x, y shifts and rotations around the beam axis.

A further embodiment will now be described, with specific application to metrology using measurement illumination for example, SXR metrology, which may be generated via high-harmonic generation (HHG) techniques. In SXR metrology, a target may be illuminated by a SXR spectrum (e.g., comprising wavelengths within the 10 nm - 20 nm wavelength range). The diffraction pattern may be captured by an image sensor. Processing the diffraction pattern results in estimates of parameters of interest such as overlay or critical dimension. As has been mentioned, targets can generally be 1D-periodic or 2D-periodic. For a 1D-periodic target, a symmetric, conical measurement configuration may be chosen. Generally, different pixels on the image sensor receive different wavelengths ($\lambda$) and diffraction orders ($m$) and mapping from pixel position to order(s) and wavelength(s) is straightforward.

Optionally, two diffraction patterns are captured, with the sample being rotated 180 deg (in-plane) between the first and the second acquisition. For both acquisitions, the plane of incidence may be parallel to the lines of the target being measured in a symmetrical, conical configuration.

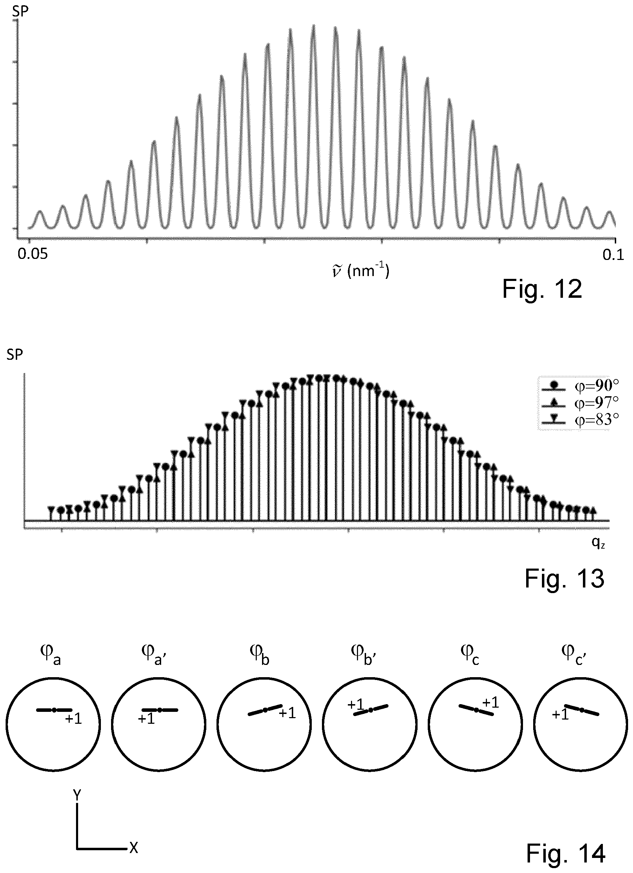

In one example, the spectrum has a comb-like spectrum, optionally the spectrum is a SXR spectrum which may be generated through HHG as illustrated in Figure 12. Figure 12 is a plot of spectral power SP against wavenumber $\tilde{v}$ (or wavelength). Each of the peaks is at an odd multiple of the pump/drive radiation wavenumber (before high-harmonic generation). Depending on the design of the SXR source, even multiples may also be present; in the following description, only odd multiples are assumed to be present. It will be straightforward to adapt the method to the case of both even and odd multiples being present. The spectral power between the peaks is close to zero. A consequence of this is that the reflectance for the corresponding wavelength components cannot be measured. Missing wavelength values in the illumination spectrum reduces the amount of information obtained from the measurement compared to measuring with a continuous spectrum without missing values. This, in particular, may lead to artifacts in the autocorrelation/Fourier analysis. Even if the spectral intensity is not zero between the peaks, but merely at a much lower value than the peaks, the result will be a low signal/noise ratio for those wavelengths.

It is therefore desirable to generate a spectrum in ($m$, $q_z$) representation that is continuous, or at least more continuous than with conventional HHG generation. Here, m is the diffraction order number. The mapping ($m$, $\lambda$) $\rightarrow$ ($m$, $q_z$) (described above) is affected by an azimuthal angle $\varphi$ (in-plane target rotation), the angle of incidence, the pitch of the target, and the index of refraction $n$ of the target (or of a selected layer in the target). The angle $\varphi = \pm 90$ deg is

defined as symmetric, conical diffraction; 0 and 180 deg are planar diffraction.

Figure 13 is a plot of spectral power SP against $q_z$ values illustrating a mapping of a discrete-wavelength spectrum to $q_z$ values for three azimuthal angles $\varphi$. In this specific example, the three different azimuthal angles are: 90 deg, 83 deg and 97 deg. The 90 deg spectrum corresponds to the spectrum of Figure 12, mapped to $q_z$ space. The other two spectra show that, by varying the azimuthal angle, the positions of these peaks move in $q_z$ space. The position of the peaks in $q_z$ space is essentially the same for $\varphi$ =83 deg and $\varphi$ =97 deg; i.e., a shift of 7 degrees in either direction results in essentially the same shift in peak positions. The magnitude of the azimuthal angle shift (in this specific example, 7 degrees) is chosen such that the spectral peaks are located between the spectral peaks of the spectrum for the $\varphi$ = 90 deg measurement, e.g., each peak in the $\varphi$ =97 deg spectrum is approximately equidistant from each peak of a respective pair of adjacent peaks in the $\varphi$ = 90 deg spectrum. The magnitude of the shift to achieve this will be dependent on a number of parameters including the shift in $\varphi$, target pitch, angle of incidence, and refractive index of the target.

As such, it is proposed to perform measurements over at least a pair of measurement acquisitions, a first acquisition at a first azimuthal angle (e.g., a conventional azimuthal angle such as $\varphi$ = ±90 deg) and a second acquisition at a second azimuthal angle chosen/optimized such that the spectral peaks of the captured spectrum of the second acquisition are located between (e.g., approximately equidistantly) the spectral peaks of the captured spectrum of the first acquisition. These measurements can then be combined, resulting in a more continuous spectrum without missing components (i.e., the combined spectrum comprises components at locations in $q_z$ space which correspond to all integer multiples (even and odd) of the drive radiation wavenumber over a wavenumber range). Referring to the specific example illustrated, combining the measurements corresponding to $\varphi$ =90 deg and $\varphi$ =97 deg (or 83 deg) in ($m$, $q_z$) space would result in a spectrum without missing components.

For a 1D-periodic target, an angle $\alpha$ may be chosen such that the spectral peaks in $q_z$ representation for azimuthal angle $\varphi_a = \pi/2$ and $\varphi_b = (\pi/2 + \alpha)$ are interleaved (angles now in radians). These spectral peaks of both spectra may be approximately equally spaced. The angle $\alpha$ is the azimuthal angle shift described above, e.g., 7 deg or 0.12 rad in the specific example illustrated.

Two reflectance spectra $R^{(a)}(m, q_z)$ and $R^{(b)}(m, q_z)$ are obtained for these two azimuthal angles respectively. These two spectra may have noisy or missing data at $q_z$ values corresponding to wavelengths with low or zero spectral power. They may be combined into a single spectrum $R^{(c)}(m, q_z)$ that does not have missing data and/or is less noisy.

There are a number of ways that the two spectra may be combined, e.g., a simple average may be taken. In general, a function $f(R_a, R_b)$ can be defined to combine two spectra. By way of another example, a standard error $\sigma_{a,b}(q_z)$ may be assigned to each component and a weighted average taken, for example:

$$R(m, q_z) = f\left(R_a(m; q_z), R_b(m; q_z)\right) \equiv \frac{\dfrac{R^{(a)}(m, q_z)}{\sigma_a(m, q_z)^2} + \dfrac{R^{(b)}(m, q_z)}{\sigma_b(m, q_z)^2}}{\dfrac{1}{\sigma_a(m; q_z)^2} + \dfrac{1}{\sigma_b(m; q_z)^2}} . \quad \text{(Eq. 12)}$$

There are many variations possible; for example, the analysis may be performed on diffracted intensities ($I(m, q_z)$) rather than diffraction efficiencies and/or the weighting factors may differ from $1/\sigma^2$.

The combined signal $R(q_z)$ may then be used as an input into further processing, e.g., to determine a parameter of interest. This signal could also be transformed back into wavelength representation for use with algorithms that expect such input. The individual signals $R^{(a)}$ and $R^{(b)}$ could be fed into a machine-learning algorithm without combining them into a combined signal.

Angle $\alpha$ may be chosen using a trial and error optimization, for example by varying the azimuthal angle and observing the resultant peak positions in the measurement spectrum in $q_z$ space, selecting the azimuthal angle corresponding to the spectral peaks being in the desired interleaved positions with respect to the spectrum corresponding to $\varphi$ = $\pi/2$. As has been described, it is possible to map known wavelengths (from the SXR illumination spectrum) to $q_z$ values.

The table below list a number of specific example values for angle $\alpha$, for a number of different pitches. All values assume a spectrum with odd harmonics of 1030 nm around 15 nm wavelength, angle of incidence 30 deg, and target refractive index $n$ = 0.95. Note that at pitches ≥80 nm, the peak shifts in $q_z$ representation become nonlinear with $\alpha$.

| Pitch (nm) | $\alpha$ (deg) |
| --- | --- |
| 20 | 3.5 |
| 30 | 5 |
| 40 | 7 |

(continued)

| Pitch (nm) | $\alpha$ (deg) |
|---|---|
| 60 | 11 |
| 80 | 12 |

This measurement spectrum configuration embodiment may be combined with tool-asymmetry correction concepts described herein. As a first example, a basic tool-asymmetry correction for 1D-periodic targets will be described. This addresses the large tool asymmetry that will be introduced by this spectrum configuration embodiment, but not the smaller tool asymmetry due to minor alignment errors or polarization effects.

In such an embodiment, three measurement acquisitions are performed for three target orientations: azimuth $\varphi_a = \dfrac{\pi}{2}$, $\varphi_b = (\pi/2 + \alpha)$, and $\varphi'_b = \varphi_b - \pi$. Referring to Equation 12, the combined spectrum can be evaluated as:

$$R(m; q_z) = \begin{cases} f(R^{(a)}, R^{(b)}) & (m > 0) \\ f(R^{(a)}, R^{(b')}) & (m < 0) \end{cases}.$$

This may be the other way around, e.g., $R^{(b')}$ may be used for positive m, i.e.

$$R(m; q_z) = \begin{cases} f(R^{(a)}, R^{(b)}) & (m < 0) \\ f(R^{(a)}, R^{(b')}) & (m > 0) \end{cases}.$$

Alternatively the measurements may be combined in such a way that no measured data is discarded.

In a further embodiment, (again for 1D-periodic targets) a full tool-asymmetry correction may be performed. However this does require 6 measurement acquisitions, which is more than is desirable. The method comprises performing the 6 measurement acquisitions at target orientations $\varphi_a$, $\varphi_b$, $\varphi_{a'} = \varphi_a - n$, $\varphi_{b'} = \varphi_b - \pi$, $\varphi_c = \pi/2 - \alpha$, $\varphi'_c = \varphi_c - \pi$. An example captured diffraction pattern for each of these target orientations is illustrated in Figure 14.

The tool-asymmetry-corrected spectra may then be constructed according to:

$$R_{\text{TAC},a}(m, q_z) = \frac{1}{2}[R_a(m, q_z) + R_{a'}(m, q_z)]$$

$$R_{\text{TAC},b}(m, q_z) = \frac{1}{2}[R_b(m, q_z) + R_{c'}(m, q_z)]$$

$$R_{\text{TAC},c}(m, q_z) = \frac{1}{2}[R_c(m, q_z) + R_{b'}(m, q_z)]$$

These spectra can then be combined (for example) as:

$$R(m, q_z) = \frac{\dfrac{R_{TAC,a}(m, q_z)}{\sigma_a(m, q_z)^2} + \dfrac{R_{TAC,b}(m, q_z)}{\sigma_b(m, q_z)^2} + \dfrac{R_{TAC,c}(m, q_z)}{\sigma_c(m, q_z)^2}}{\dfrac{1}{\sigma_a^2} + \dfrac{1}{\sigma_b^2} + \dfrac{1}{\sigma_c^2}} \quad (\text{Eq. } 13)$$

It is expected that this approach will correct for all sources of tool asymmetry. However, if this is not the case, then a further embodiment may comprise modifying the 1D-periodic targets to become quasi-2D targets. For example, a 1D-periodic grating with a first pitch could be cut with a larger pitch, e.g., larger by at least an order of magnitude, to form a 2D-periodic pattern with a first pitch for the x-direction and a second pitch for the y-direction. The tool-asymmetry correction scheme described in Figures 9 or 10 can then be applied to this target. Diffraction efficiencies for different orders ($m_x, m_y$) can than be combined as has been described in the measurement spectrum configuration embodiments already described (e.g., a weighted average).

In such a target, it would be expected to see many more y-diffraction orders than only those for which the rotation angle is optimal for interleaving the spectral peaks in $q_z$ representation. It is possible to perform Fourier analysis on the TA-corrected diffraction efficiency $R_{mq}(m_x, m_y, q_z)$, resulting in an autocorrelation dataset in x, y, and z. The y-dependency may be discarded, for example, by integrating the autocorrelation signal over y.

A further embodiment will now be described in the context of overlay, for example diffraction-based overlay (DBO) metrology. In DBO metrology, two differently biased targets may be measured to estimate overlay OV. More specifically, overlay may be estimated from two asymmetry measurements $A_+$ and $A_-$ (relating to targets with bias +b and -b, respectively, i.e., biases of the same magnitude and a different direction), according to:

$$OV = b\,\frac{A_+ + A_-}{A_+ - A_-}.$$

Many refinements on this general concept exist. One such method may comprise obtaining a phase difference parameter or overlay-like parameter $X_0$ (e.g., expressed in nanometers) from a single target, or to combine measurements from two biased targets according to:

$$OV = b\,\frac{X_0^+ + X_0^-}{X_0^+ - X_0^-}. \quad [\text{Eq. }14]$$

The method may comprise, in summary, mapping a diffraction efficiency $R_{m\lambda}(m, \lambda)$ to reciprocal space as $R_{mq}(m, q_z)$; e.g., using methods described above. This representation may then be Fourier-transformed into complex-valued representation $R_{mz}(m, Z)$, where Z values correspond to layer thicknesses in the target structure. The overlay-like parameter $X_0(Z)$ is then related to the phase difference $\Delta\varphi_m(Z)$ between $R_{mZ}(m, Z)$ and $R_{mZ}(-m, Z)$ by:

$$X_0(m, Z) = \frac{\Delta\varphi(m, Z)}{4\pi m}\,p, \quad [\text{Eq. }15]$$

where p is the pitch of the target. This can be generalized to 2D-periodic targets and multiple diffraction order pairs ($m_x, m_y$), yielding $X_0$ and $Y_0$. For 2D-periodic targets, the tool-asymmetry correction techniques described herein may be used to obtain $R_{mq}(m_x, m_y, \lambda)$. Note that, while in the earlier description XYZ were defined to be tool coordinates, here they are in-target coordinates.

For such an overlay metrology method, better accuracy is obtained by using biased targets. In the 2D overlay example, there may be four biased targets having (for example) biases (x, y): ($b_x$, 0), (-$b_x$, 0), (0, $b_y$), (0, -$b_y$) where $b_x$ is the x-direction bias and $b_y$ is the y-direction bias. Optionally the x-direction bias $b_x$ and the y-direction bias $b_y$ are different. By using such biased targets in combination with Equation Eq. 15, accuracy is improved, particularly for y-direction overlay.

However, a set of four biased targets occupies a significant area on-die, and requires four measurement acquisitions, resulting in a fourfold lower throughput compared to measuring a single unbiased target.

A large contribution to the error in the $X_0$, $Y_0$ values from Equation Eq. 15 are as a result of systematic errors. One such error source, for example, may result from a poor estimation or assumption of target layer refractive indices. The refractive index of the target layers as a function of wavelength may be different from that assumed when calculating $R_{mq}(m, q_z)$. In addition, Fourier-transforming over a limited domain in $q_z$ space results in a systematic error.

Because these errors are systematic, it is proposed to use biased targets only in an initial calibration. Only a small number of biased targets will be required for such a calibration, and it may not be necessary to perform a calibration for every wafer. Calibration data (e.g., one or more calibration relationships, or called one or more calibrated relationships) may be obtained via the calibration.

In such an embodiment, the majority of overlay targets may be single (i.e., single pad) unbiased targets (or more generally all comprising a single bias, preferably zero), such that only one such target is required per location rather than four. These unbiased targets may, for example, be placed in-die. The biased calibration targets (e.g., with multiple biases) can be placed in a scribe lane. A die is a small block of semiconducting material on which a given functional circuit is fabricated. Typically, integrated circuits are produced in large batches on a single substrate through processes such as photolithography. The wafer is cut (diced) into many pieces, each containing one copy of the circuit. Each of these pieces is called a die. In-die means the metrology target is located inside a die. The scribe lane is the area that separates dies on a substrate. This area is required to be able to dice (saw) the substrate into individual dies.

As an alternative to measuring targets designed and exposed specifically for metrology purposes, the metrology may be performed directly on the product (on-product metrology) provided it is sufficiently regularized (e.g., memory structure). In this way, no real-estate is sacrificed for overlay metrology. Also, overlay as measured on a target may be different from the wanted overlay of a functional product structure (e.g. memory cells) on the die, due to lithographic artefacts related to the edges of the target; by measuring directly on the structure, this issue is avoided. In the context of this disclosure, the term target may describe a target designed and exposed specifically for metrology purposes or any other structure including functional product structure when metrology is performed thereon.

The calibration may comprise measuring multiple biased targets (two or more for 1D-periodic targets, four or more for 2D-periodic targets) and determining from the resultant measurement values, the relationship (a calibration relationship) between overlay and the overlay-like parameter $X_0$ (and between overlay and overlay-like parameter $Y_0$ for 2D). Optionally the biases are different. Once this calibration relationship is calibrated (e.g., per direction) it may be used in a production phase to convert overlay-like parameter $X_0$ (or $Y_0$), as determined for example using Equation Eq. 15 from metrology on an unbiased (e.g., in-die) target, to an overlay value.

In a specific example, it may be assumed that the relationship between overlay and the overlay-like parameter is linear (other more complex/higher order relationships may be used instead). As such, the method may comprise determining the coefficients $a, c$ in the relation $OV_x = (aX_0 + c)$, and analogously determining the coefficients $d, e$ in the relation $OV_y = (dY_0 + e)$, where $OV_x$ is x-direction overlay and $OV_y$ is y-direction overlay. With two targets per dimension, either $a$ or $c/d$ or $e$ can be estimated; with three targets per dimension, both $a$ and $c/d$ and $e$ can be estimated. As such, the calibration will be improved with three targets per direction. The coefficient values $a, c,$ (and/or $d, e$) can then be used to convert a value for $X_0$ (and/or $Y_0$), e.g., as obtained from an unbiased target, to an overlay value.

Knowledge of the coefficients $a, c$ (and $d, e$) also enables more accurate estimation of the refractive index $n(\tilde{v})$ as a function of wavenumber, or at least a mean refractive index value across a layer stack (e.g., such as the layer(s) between the upper and lower patterned layers). For this, it may be noted that Equation 7 is an approximation for refractive index $n = 1$. A more accurate expression is:

$$q_z = \tilde{v}\, n(\tilde{v})\, (\cos\theta_1 + \cos\theta_2),$$

where the angles $\theta_1, \theta_2$ are also dependent on $n(\tilde{v})$, according to Snell's law. One can modify $n(\tilde{v})$, for example by adding a constant or a linear function of $\tilde{v}$, such that the coefficients $a, c, d, e$ as described above get values 1, 0, 1, 0, respectively. This can be done by trial and error or using an optimizing algorithm. This enables a more accurate measurement of layer thicknesses, or if the thicknesses are known, provide information on the chemical composition of the layer (such as the amount of oxidation); in SXR, the refractive index is mostly the weighted average of refractive indices of the constituting chemical elements.

Further embodiments are disclosed in the subsequent numbered clauses:

1. A method of measuring a target on a substrate using a metrology tool comprising an illumination source operable to emit an illumination beam for illuminating the target and a metrology sensor for collecting the scattered radiation having been scattered by the target, the surface of said substrate defining a substrate plane extending over a first tool direction and a second tool direction orthogonal to said first tool direction, where the first tool direction, second tool direction and a third tool direction orthogonal said first tool direction and second tool direction together defines a tool coordinate system, the method comprising:

performing at least one pair of measurement acquisitions, said at least one pair of measurement acquisitions comprising a first measurement acquisition of the target at a first target orientation with respect to the illumination beam; and a second measurement acquisition of the target at a second target orientation with respect to the illumination beam, wherein said first target orientation is defined by a target angle between a target coordinate system and said tool coordinate system around an axis perpendicular to the substrate plane, wherein said target angle for at least one measurement acquisition of said at least one pair of measurement acquisitions is an oblique angle; and

determining a combined measurement acquisition from the first measurement acquisition and second measurement acquisition.

2. A method according to clause 1, wherein the target comprises a two-dimensional target having a first periodicity in a first target direction of the target coordinate system and a second periodicity in a second target direction of the target coordinate system.

3. A method according to clause 2, wherein said first target orientation and said second target orientation are such that a selected pair of complementary diffraction orders generates a diffraction pattern which has reflection symmetry with respect to an axis of the metrology sensor along said second tool direction.

4. A method according to clause 3, comprising:
calculating said target angle based on:

> cell dimensions of a unit cell of said target in the first target direction and the second target direction; and
> order numbers of a selected pair of complementary diffraction orders in said first target direction and second target direction.

5. A method according to clause 4, wherein said cell dimensions are $(L_x, L_y)$ in said first target direction and said second target direction respectively, said order numbers of said pair of complementary diffraction orders are $(m_x, m_y)$, $(-m_x, -m_y)$ and said target angle $\alpha$ is defined by:

$$\alpha = \mathrm{atan2}(m_y L_x, m_x L_y)$$

6. A method according to any preceding clause, wherein said second target orientation is defined by said target angle plus 180 degrees.

7. A method according to any preceding clause, comprising:

> selecting at least two of said pairs of complementary diffraction orders;
> performing said pair of measurement acquisitions for each of said pairs of complementary diffraction orders;
> mapping measured pixel values for each of said diffraction orders within each measurement acquisition of said pairs of measurement acquisitions to a respective spectrum as a function of a wavelength-related quantity; and
> determining said combined measurement acquisition from a combination of each of said pair of measurement acquisitions.

8. A method according to clause 6 or 7, comprising determining a parameter of interest from said combined measurement acquisition.

9. A method according to clause 8, wherein the parameter of interest comprises overlay or side wall angle.

10. A method according to any of clauses 6 to 9, wherein said at least two of said pairs of complementary diffraction orders comprises at least four of said pairs of complementary diffraction orders.

11. A method according to any of clauses 6 to 9, wherein said method comprises:

> estimating each of said spectra as a continuous function of said target angle by interpolation; and
> evaluating said spectra with other angles corresponding to the other pairs of complementary diffraction orders.

12. A method according to any of clauses 7 to 11, wherein said mapping step comprises a step of transforming each of said spectra from a wavelength representation to an inverse coordinate representation in inverse pupil space or a pupil coordinate representation in pupil space.

13. A method according to any of clauses 7 to 12, wherein said mapping step comprises:

> binarizing each of said first measurement acquisitions and second measurement acquisitions based on user-defined or automatically obtained threshold; and
> segmenting each of the binarized first measurement acquisitions and second measurement acquisitions to obtain per-order masks.

14. A method according to clause 13, further comprising:
optimizing contours obtained from said segmenting step by applying morphological close and open transformations sequentially.

15. A method according to any preceding clause, wherein the illumination beam illuminates the substrate at a non-normal incidence angle.

16. A method according to any preceding clause, wherein the illumination beam illuminates the substrate in a plane defined by said first tool direction and said third tool direction or a plane defined by said second tool direction and said third tool direction.

17. A method according to any preceding clause, wherein the metrology tool comprises a detector operable to capture an intensity spectrum.

18. A method according to any of clauses 1 to 16, wherein the metrology tool comprises an image based detector and the method comprises comprising using a mask in a pupil plane to select said diffraction orders.

19. A method according to any preceding clause, wherein the measurement acquisition is a corrected measurement acquisition being corrected for asymmetry contributions due to the illumination beam and/or metrology sensor.

20. A method to measure a target on a substrate plane with an illumination of a metrology tool, comprising: making a first measurement; rotating the target with respect to a direction orthogonal to the substrate plane with a non-orthogonal angle; and making a second measurement.

21. A method according to clause 20, wherein the target is a two-dimensional target with periodicities in two orthogonal directions on the substrate plane, optionally the periodicities in two directions is bigger than or comparable to half of the illumination wavelength.

22. A method according to clause 20 or 21, wherein the illumination illuminates the wafer with an oblique incidence.

23. A method according to any of clauses 20 to 22, wherein the method further comprising:

combining the first measurement and the second measurement to correct an asymmetry introduced by the metrology tool.

24. A method according to any preceding clause, wherein each measurement acquisition is performed using an illumination beam, and said first measurement acquisition results in a first measurement signal and said second measurement acquisition results in a second measurement signal, and

wherein said first orientation and second orientation are such that a second spectrum of the second measurement signal comprises peaks at spectral locations in reciprocal space which are interleaved with peaks of a first spectrum of the first measurement signal in said reciprocal space.

25. A method according to clause 24, wherein said determining a combined measurement acquisition from the first measurement acquisition and second measurement acquisition comprises combining at least said first measurement acquisition and second measurement acquisition as a weighted average.

26. A method according to clause 24 or 25, wherein each peak in the second spectrum is approximately equidistant from each peak of a respective pair of adjacent peaks in the first spectrum.

27. A method according to any of clauses 24 to 26, comprising determining said second target orientation based on a trial and error optimization of said second spectrum.

28. A method according to any of clauses 24 to 27, wherein said at least one pair of measurement acquisitions and at least one pair of measurement signals comprises respectively at least a third measurement acquisition at a third target orientation and a corresponding third measurement signal, wherein said third target orientation differs from said second target orientation by 180 degrees.

29. A method according to any of clauses 24 to 27, wherein said at least one pair of measurement acquisitions and at least one pair of measurement signals comprises respectively at least a third measurement acquisition at a third target orientation and a corresponding third measurement signal, a fourth measurement acquisition at a fourth target orientation and a corresponding fourth measurement signal, fifth measurement acquisition at a fifth target orientation and a corresponding fifth measurement signal and a sixth measurement acquisition at a sixth target orientation and a corresponding sixth measurement signal wherein said third target orientation differs from said second target orientation by 180 degrees, the fourth target orientation differs from said first target orientation by 180 degrees, said fifth target orientation is 90 degrees less the difference of said second target orientation and said first target orientation and said sixth target orientation differs from said fifth target orientation by 180 degrees.

30. A method of measuring a target on a substrate using an illumination beam, the method comprising:

performing at least one pair of measurement acquisitions to obtain at least one pair of measurement signals, said at least one pair of measurement acquisitions comprising a first measurement acquisition of the target at a first azimuthal angle with respect to the illumination beam to obtain a first measurement
signal of the pair of measurement signals; and a second measurement acquisition of the target at a second azimuthal angle with respect to the illumination beam to obtain a second measurement signal of the pair of measurement signals; and
using the first measurement signal and the second measurement signal to determine a parameter of interest;

wherein said second azimuthal angle is such that a second spectrum of the second measurement signal comprises peaks at spectral locations in reciprocal space which are interleaved with peaks of a first spectrum the first measurement signal in said reciprocal space.

31. A method according to clause 30, comprising combining the measurement signals of said at least a pair of measurement signals to obtain a combined measurement signal.

32. A method according to clause 31, wherein said measurement signals are combined as a weighted average.

33. A method according to any of clauses 30 to 32, wherein each peak in the second spectrum is approximately equidistant from each peak of a respective pair of adjacent peaks in the first spectrum.

34. A method according to any of clauses 30 to 33, comprising determining said second azimuthal angle based on a trial and error optimization of said second spectrum.

35. A method according to any of clauses 30 to 34, wherein said at least one pair of measurement acquisitions and at least one pair of measurement signals comprises respectively at least a third measurement acquisition at a third azimuthal angle and a corresponding third measurement signal, wherein said third azimuthal angle differs from said second azimuthal angle by 180 degrees.

36. A method according to any of clauses 30 to 34, wherein said at least one pair of measurement acquisitions and at least one pair of measurement signals comprises respectively at least a third measurement acquisition at a third azimuthal angle and a corresponding third measurement signal, a fourth measurement acquisition at a fourth azimuthal angle and a corresponding fourth measurement signal, fifth measurement acquisition at a fifth azimuthal angle and a corresponding fifth measurement signal and a sixth measurement acquisition at a sixth azimuthal angle and a corresponding sixth measurement signal wherein said third azimuthal angle differs from said second azimuthal angle by 180 degrees, the fourth azimuthal angle differs from said first azimuthal angle by 180 degrees, said fifth azimuthal angle is 90 degrees less the difference of said second azimuthal angle and said first azimuthal angle and said sixth azimuthal angle differs from said fifth azimuthal angle by 180 degrees.

37. A method of measuring overlay from a target, the method comprising:

determining a phase difference parameter related to a phase difference between a first measurement signal related to a first diffraction order of scattered radiation from the target and a second measurement signal related to a second diffraction order of said scattered radiation, wherein said first diffraction order and second diffraction order are complementary diffraction orders;
obtaining one or more calibrated relationships, relating said phase difference parameter to an overlay parameter; and
using said one or more calibrated relationships to convert said phase difference parameter into an overlay parameter.

38. A method according to clause 37, wherein said target comprises a single 1-dimensional or single 2-dimensional periodic structure.

39. A method according to clause 37, wherein the target comprises a 2-dimensional periodic structure; said one or more calibrated relationships comprises one or more calibrated relationships per dimension of said 2-dimensional periodic structure and said method comprises;

determining the phase difference parameter for each of said dimensions;

using said one or more calibrated relationships relating to a first dimension of said dimensions to convert the phase difference parameter relating to said first dimension into an overlay parameter relating to said first dimension; and
using said one or more calibrated relationships relating to a second dimension of said dimensions to convert the phase difference parameter relating to said second dimension into an overlay parameter relating to said second dimension.

40. A method according to any of clauses 37 to 39, wherein said phase difference parameter is related to a phase difference between a complex-valued representation of the first measurement signal and a complex-valued representation of the second measurement signal.

41. A method according to clause 40, wherein each complex-valued representation of a measurement signal is obtained by:

mapping a captured measurement signal to reciprocal space to obtain a mapped measurement signal; and
Fourier transforming the mapped measurement signal.

42. A method according to any of clauses 37 to 41, wherein said target is an in-die target.

43. A method according to any of clauses 37 to 42, wherein said target comprises functional product structure.

44. A method according to any of clauses 37 to 43, comprising a calibration step to calibrate said one or more calibrated relationships; said calibration step comprising:

measuring a plurality of calibration targets to obtain calibration data, said plurality of calibration targets comprising at least two per measurement direction; and
determining said one or more calibrated relationships per measurement direction, by determining a relationship between the phase difference parameter and overlay parameter using said calibration data;

wherein said at least two of said calibration targets per measurement direction each have a different bias.

45. A method according to clause 44, wherein said at least two of said calibration targets per measurement direction each have bias of the same magnitude and a different direction.

46. A method according to clause 45, wherein said plurality of calibration targets are located in a scribe lane of a substrate.

47. A method according to any of clauses 44 to 46, wherein said plurality of calibration targets comprising at least three per measurement direction.

48. A method according to any of clauses 37 to 47, comprising using said one or more calibrated relationships to estimate the refractive index as a function of wavelength or the mean refractive index value across a layer stack.

49. A method according to any of clauses 37 to 48, wherein the first diffraction order is a +1 diffraction order and the second diffraction order is a -1 diffraction order.

50. A computer program comprising computer readable instruction operable to perform at least the processing and determining a position steps of the method of any of clauses 1 to 49.

51. A processor and associated storage medium, said storage medium comprising the computer program of clause 50 such that said processor is operable to perform the method of any of clauses 1 to 49.

52. A metrology device comprising the processor and associated storage medium of clause 51 so as to be operable to perform the method of any of clauses 1 to 49.

53. A lithographic cell comprising a lithographic apparatus and the metrology device of clause 52.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. A method of measuring a target on a substrate using a metrology tool comprising an illumination source operable to emit an illumination beam for illuminating the target and a metrology sensor for collecting the scattered radiation having been scattered by the target, the surface of said substrate defining a substrate plane extending over a first tool direction and a second tool direction orthogonal to said first tool direction, where the first tool direction, second tool direction and a third tool direction orthogonal said first tool direction and second tool direction together defines a tool coordinate system, the method comprising:

   performing at least one pair of measurement acquisitions, said at least one pair of measurement acquisitions comprising a first measurement acquisition of the target at a first target orientation with respect to the illumination beam; and a second measurement acquisition of the target at a second target orientation with respect to the illumination beam, wherein said first target orientation is defined by a target angle between a target coordinate system and said tool coordinate system around an axis perpendicular to the substrate plane, wherein said target angle for at least one of said at least one pair of measurement acquisitions is an oblique angle; and
   determining a combined measurement acquisition from the first measurement acquisition and second measurement acquisition.

2. A method according to claim 1, wherein the target comprises a two-dimensional target having a first periodicity in a first target direction of the target coordinate system and a second periodicity in a second target direction of the target coordinate system.

3. A method according to claim 2, wherein said first target orientation and said second target orientation are such that a selected pair of complementary diffraction orders generates a diffraction pattern which has reflection symmetry with respect to an axis of the metrology sensor along said second tool direction.

4. A method according to claim 3, comprising:
   calculating said target angle based on:

   cell dimensions of a unit cell of said target in the first target direction and the second target direction; and
   order numbers of a selected pair of complementary diffraction orders in said first target direction and second target direction.

5. A method according to claim 4, wherein said cell dimensions are $(L_x, L_y)$ in said first target direction and said second target direction respectively, said order numbers of said pair of complementary diffraction orders are $(m_x, m_y)$, $(-m_x, -m_y)$ and said target angle $\alpha$ is defined by:

$$\alpha = \mathrm{atan2}(m_y L_x,\ m_x L_y)$$

6. A method according to any preceding claim, wherein said second target orientation is defined by said target angle plus 180 degrees.

7. A method according to any preceding claim, comprising:

   selecting at least two of said pairs of complementary diffraction orders;
   performing said pair of measurement acquisitions for each of said pairs of complementary diffraction orders;
   mapping measured pixel values for each of said diffraction orders within each measurement acquisition of said pairs of measurement acquisitions to a respective spectrum as a function of a wavelength-related quantity; and

determining said combined measurement acquisition from a combination of each of said pair of measurement acquisitions.

8. A method according to any of claims 6 to 7, wherein said at least two of said pairs of complementary diffraction orders comprises at least four of said pairs of complementary diffraction orders.

9. A method according to any of claims 6 to 7, wherein said method comprises:

estimating each of said spectra as a continuous function of said target angle by interpolation; and
evaluating said spectra with other angles corresponding to the other pairs of complementary diffraction orders.

10. A method according to any of claims 7 to 9, wherein said mapping step comprises a step of transforming each of said spectra from a wavelength representation to an inverse coordinate representation in inverse pupil space or a pupil coordinate representation in pupil space.

11. A method according to any of claims 7 to 10, wherein said mapping step comprises:

binarizing each of said first measurement acquisitions and second measurement acquisitions based on user-defined or automatically obtained threshold; and
segmenting each of the binarized first measurement acquisitions and second measurement acquisitions to obtain per-order masks, optionally the method further comprising:

optimizing contours obtained from said segmenting step by applying morphological close and open transformations sequentially.

12. A method according to any preceding claim, wherein the illumination beam illuminates the substrate at a non-normal incidence angle.

13. A method according to any preceding claim, wherein the illumination beam illuminates the substrate in a plane defined by said first tool direction and said third tool direction or a plane defined by said second tool direction and said third tool direction.

14. A method according to any of claims 1 to 13, wherein the metrology tool comprises an image based detector and the method comprises comprising using a mask in a pupil plane to select said diffraction orders.

15. A method according to any preceding claim, wherein the measurement acquisition is a corrected measurement acquisition being corrected for asymmetry contributions due to the illumination beam and/or metrology sensor.

Fig. 1

Fig. 2

Fig. 3

LA

SC1

SC3

CL

0

-1    +1

MT

SC2

2

4

SM1

Z

X

PU

Fig. 4

W

I

6

λ

Z

8

X

Fig. 5

Fig. 6

Fig. 7

$I_0(X, Y)$ + $I_{180}(-X, Y)$ = $I_{TAC}(X, Y)$

(a)

$I_0(X, Y)$ + $I_{180}(-X, -Y)$ = $I_{TAC}'(X, Y)$

(b)

Fig. 8

Fig. 9

Fig. 10

(a)

(b)

Fig. 11

SP

0.05                                                    0.1
$\tilde{\nu}$ (nm$^{-1}$)

Fig. 12

SP

| | $\varphi=90°$ |
| | $\varphi=97°$ |
| | $\varphi=83°$ |

q$_z$

Fig. 13

$\varphi_a$      $\varphi_{a'}$      $\varphi_b$      $\varphi_{b'}$      $\varphi_c$      $\varphi_{c'}$

+1      +1      +1      +1      +1      +1

Y
X

Fig. 14

Europäisches
Patentamt

European
Patent Office

Office européen
des brevets

# EUROPEAN SEARCH REPORT

**Application Number**

EP 21 19 2381

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/357154 A1 (OH SEUNG HWA [KR] ET AL) 14 December 2017 (2017-12-14) * claims 1-3; figures 1,5 * | 1,6,12, 13 | INV. G03F7/20 |
| X | WO 2019/139685 A1 (KLA TENCOR CORP [US]) 18 July 2019 (2019-07-18) * paragraph [0030]; figure 3 * | 1 | |
| A,D | US 2016/161863 A1 (DEN BOEF ARIE JEFFREY [NL] ET AL) 9 June 2016 (2016-06-09) * paragraph [0084] * | 1-15 | |
| A | US 2013/215404 A1 (DEN BOEF ARIE JEFFREY [NL]) 22 August 2013 (2013-08-22) * paragraph [0105] – paragraph [0114]; figures 12,13 * | 1-15 | |

TECHNICAL FIELDS
SEARCHED      (IPC)

G03F

The present search report has been drawn up for all claims

| Place of search | Date of completion of the search | Examiner |
|---|---|---|
| Munich | 9 February 2022 | Angioni, Catherine |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

............................................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 21 19 2381

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2022

| Patent document cited in search report | Publication date | Patent family member(s) | Publication date |
|---|---|---|---|
| US 2017357154 A1 | 14-12-2017 | KR 20170141312 A | 26-12-2017 |
| | | US 2017357154 A1 | 14-12-2017 |
| WO 2019139685 A1 | 18-07-2019 | CN 111542784 A | 14-08-2020 |
| | | JP 2021511532 A | 06-05-2021 |
| | | KR 20200099615 A | 24-08-2020 |
| | | SG 11201913459R A | 29-07-2020 |
| | | TW 201939171 A | 01-10-2019 |
| | | US 2020124982 A1 | 23-04-2020 |
| | | WO 2019139685 A1 | 18-07-2019 |
| US 2016161863 A1 | 09-06-2016 | CN 107111250 A | 29-08-2017 |
| | | CN 110553602 A | 10-12-2019 |
| | | EP 3224676 A1 | 04-10-2017 |
| | | JP 6616416 B2 | 04-12-2019 |
| | | JP 6872593 B2 | 19-05-2021 |
| | | JP 2017537352 A | 14-12-2017 |
| | | JP 2020038384 A | 12-03-2020 |
| | | KR 20170085116 A | 21-07-2017 |
| | | KR 20200050478 A | 11-05-2020 |
| | | KR 20210105446 A | 26-08-2021 |
| | | SG 11201704036U A | 29-06-2017 |
| | | TW 201631404 A | 01-09-2016 |
| | | TW 201736981 A | 16-10-2017 |
| | | TW 201835691 A | 01-10-2018 |
| | | US 2016161863 A1 | 09-06-2016 |
| | | US 2020103762 A1 | 02-04-2020 |
| | | US 2020301290 A1 | 24-09-2020 |
| | | WO 2016083076 A1 | 02-06-2016 |
| US 2013215404 A1 | 22-08-2013 | CN 104220932 A | 17-12-2014 |
| | | CN 105549341 A | 04-05-2016 |
| | | JP 6033890 B2 | 30-11-2016 |
| | | JP 2015510126 A | 02-04-2015 |
| | | JP 2017026638 A | 02-02-2017 |
| | | KR 20140135998 A | 27-11-2014 |
| | | KR 20170016526 A | 13-02-2017 |
| | | NL 2010211 A | 26-08-2013 |
| | | US 2013215404 A1 | 22-08-2013 |
| | | US 2015346609 A1 | 03-12-2015 |
| | | WO 2013124131 A2 | 29-08-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- CN 101515105 B

**Non-patent literature cited in the description**

- **LEMAILLET et al.** Intercomparison between optical and X-ray scatterometry measurements of FinFET structures. *Proc. of SPIE,* 2013, 8681
- **SATOSHI SUZUKI et al.** Topological structural analysis of digitized binary images by border following. *Computer Vision, Graphics, and Image Processing,* 1985, vol. 30 (1), 32-46